# EUROPÄISCHE PATENTSCHRIFT

(11) **EP 1 928 091 B1**
(45) Veröffentlichungstag und Bekanntmachung des Hinweises auf die Patenterteilung: **06.04.2011**
(21) Anmeldenummer: 06024959.6
(22) Anmeldetag: 01.12.2006
(51) Int. Cl.: H03K 17/945

(54) **Sensoreinheit mit Sicherheitssystem**
Sensing unit with safety system
Capteur avec système de sécurité

(43) Veröffentlichungstag der Anmeldung: 04.06.2008
(73) Patentinhaber: SIEMENS AKTIENGESELLSCHAFT, 80333 München (DE)
(72) Erfinder: Graupner, Dirk, 08393 Meerane (DE); Hammer, Christian, 92263 Ebermannsdorf (DE); Olbrich, Werner, 91804 Mühlheim (DE)

(56) Entgegenhaltungen:
- EP-B1- 0 691 244
- WO-A-02/42123
- DE-A1- 4 244 262
- US-A- 5 363 303

## Beschreibung

Die Erfindung betrifft eine Sensoreinheit mit Sicherheitssystem, die mindestens eine Auswerteeinheit zur Auswertung eines Signals eines Sensors und zur Erzeugung eines auf dem Signal basierenden ersten Auslösesignals aufweist. Weiterhin betrifft die Erfindung einen Positionsschalter mit einer derartigen Sensoreinheit.

Eine derartige Sensoreinheit bzw. ein derartiger Positionsschalter sind im privaten sowie im industriellen Bereich einsetzbar. Sicherheitsgerichtete Positionsschalter werden zur Detektion von Positionen von relativ zueinander beweglichen Komponenten eingesetzt. Mögliche Applikationen sind meist auf eine Vermeidung oder Verminderung einer Gefährdung gerichtet. Eine solche Gefährdung könnte beispielsweise eine Gefährdung der Gesundheit sein oder eine Gefährdung von kostbaren Produktionsmitteln, wie beispielsweise aufwendige Maschinen, teure Rohstoffe oder ähnliches. So ist beispielsweise ein Einsatz in sicherheitsgerichteten Applikationen der Gebäudetechnik, Automatisierungstechnik oder der Leittechnik denkbar.

Die sicherheitsgerichteten Positionsschalter bestehen aus mindestens zwei unabhängig voneinander beweglichen Komponenten der Sensoreinheit, die einen Sensor einschließt und dem Signalgeber. Die Sensoreinheit und der Signalgeber arbeiten im Sinne eines Schloss-Schlüssel-Prinzips zusammen. Die Sensoreinheit übernimmt die Schlossfunktion und der Signalgeber die Funktion des Schlüssels, wobei auch mehrere Signalgeber eingesetzt werden können.

Im Gegensatz zu einem mechanischen Schloss-Schlüssel-Prinzip arbeiten neuartige Positionsschalter auf berührungsloser Basis. Die Komponenten-Sensor-Einheit und Signalgeber sind folglich nicht mechanisch miteinander verbunden, sondern kommunizieren mittels elektromagnetischer Wellen.

Der applikationsbezogene Gefährdungsgrad wird über eine Risikoanalyse ermittelt. Je nach Gefährdungsgrad einer Applikation wird dieser ein so genannter Sicherheitsintegritätslevel (SIL) nach DIN EN 61508 oder einer Kategorie nach DIN EN 954-1 zugeordnet. Für den Aufbau des sicherheitsgerichteten Positionsschalters bedeutet dies umfangreiche Maßnahmen zum Schutz gegen Ausfall der sicherheitsrelevanten Teile.

Sicherheitsgerichtete Positionsschalter, welche den SIL 3-Level nach IEC 61508 bzw. die Kategorie 4 der DIN EN 954-1 erreichen, erfassen über Sensoren redundante Messsignale und führen diese zwei verschiedenen Auswerteeinheiten zu. Dabei können die Auswerteeinheiten je einen Aktor ansteuern, optional können auch beide Ergebnisse der Auswerteeinheiten vor der Ansteuerung der Aktoren miteinander verknüpft werden.

Aus der EP 0 968 567 B1 und aus der DE 103 45 819 A1 sind sicherheitsgerichtete berührungslose Positionsschalter bekannt, die ein als sicher geltendes Messsignal, welches in der Regel mehrfach codiert ist, einkanalig erfassen und dieses Messsignal zwei Auswerteeinheiten zuführen. Nach der redundanten Auswertung des Messsignals wird die Konsistenz der beiden Ausgabesignale überprüft und ausgewertet. Die beiden Auswerteeinheiten können dabei in der Lage sein, während der Auswertung miteinander zu kommunizieren. Je nach Ergebnis erfolgt dann die zweikanalige Ausgabe eines Auslösesignals.

Aus der EP 0 691 244 B1 geht eine Sensoreinheit mit Sicherheitssystem hervor, die mindestens eine Auswerteeinheit zur Auswertung eines Signals eines Sensors und zur Erzeugung eines auf dem Signal basierenden ersten Auslösesignals aufweist, wobei das Sicherheitssystem eine Überprüfungseinheit zur Funktionsprüfung der Auswerteeinheit mittels eines Testsignals umfasst.

Der Erfindung liegt die Aufgabe zugrunde, eine berührungslos arbeitende sicherheitsgerichtete Sensoreinheit für einen Positionsschalter anzugeben, der hohe Sicherheitskriterien, insbesondere die des Sicherheitslevels 3 der IEC 61508 und der Kategorie 4 der EN 954-1, erfüllt und auf eine kostengünstige Weise realisiert werden kann.

Diese Aufgabe wird bei einer Sensoreinheit der eingangs genannten Art dadurch gelöst, dass das Sicherheitssystem eine Überprüfungseinheit zur Funktionsprüfung der Auswerteeinheit mittels eines Testsignals aufweist.

Die Sensoreinheit mit Sicherheitssystem weist eine Auswerteeinheit zur Auswertung eines Signals eines Sensors auf, wobei die Auswerteeinheit zur Erzeugung eines auf dem Signal basierenden ersten Auslösesignals vorgesehen ist. Erfindungsgemäß weist das Sicherheitssystem zudem eine Überprüfungseinheit auf, die zur Funktionsprüfung der Auswerteeinheit mittels eines Testsignals vorgesehen ist wobei die Sensoreinheit einen Scrambler (SC) zur Verschlüsselung des Signals des Sensors (S, S1, S2) mittels des Testsignals (T) beinhaltet. Das von der Auswerteeinheit bearbeitete Signal und das ebenfalls von der Auswerteeinheit bearbeitete Testsignal der Überprüfungseinheit werden auf die gleiche Art und Weise an der Auswerteeinheit verarbeitet, so dass das gelieferte Ergebnis überprüft werden kann. Die Überprüfung kann beispielsweise durch einen Vergleich des von der Überprüfungseinheit generierten zweiten Auslösesignals mit dem ersten Auslösesignal erreicht werden. Aufgrund dieses Verfahrens kann der erforderliche Sicherheitslevel 3 und die Kategorie 4 der oben genannten Normen erreicht werden, insbesondere auch höhere Sicherheitslevel (SIL) der IEC 61508.

Vorteilhafterweise ist die Überprüfungseinheit zur Erzeugung eines zweiten Auslösesignals, insbesondere eines vom ersten Auslösesignal diversitären Signals oder Codes, vorgesehen, so dass auf der Basis von mindestens zwei Aussagen entschieden werden kann. Beide Auslösesignale können jeweils einen Ausgang bedienen, so dass die Ausgabe der Sensoreinheit beispielsweise zweikanalig sein kann. Gegebenenfalls können das erste und zweite Auslösesignal in einer Verknüpfungslogik, wie beispielsweise einer AND-Funktion, verknüpft werden. Eine Ausgabe in einkanaliger oder zweikanaliger Form ist dann abhängig von der Ausgabe der Verknüpfungslogik und dem zu erreichenden Sicherheitsintegritätslevel.

Vorteilhafterweise kann die Verknüpfungslogik zumindest teilweise eine Schlüssigkeitsprüfung des zweiten Auslösesignals übernehmen, wobei das zweite Auslösesignal basierend auf einen Testauslösesignal im Vergleich zum ersten Auslösesignal bewertet wird.

Vorteilhafterweise ist die Auswerteeinheit mittels eines Eingangs zur Einspeisung des Testsignals vorgesehen, wobei mittels eines einzigen Eingangs für Testsignal und Signal des Sensors ein höherer SIL Level erreicht werden kann als bei zwei separaten Eingängen.

Vorteilhafterweise ist die Auswerteeinheit zur Erzeugung des auf einer dem Testsignal basierenden Funktionsaussage vorgesehen, beispielsweise in der Form eines Testauslösesignals, wobei diese Funktionsaussage beispielsweise der Überprüfungseinheit über einen separaten Ausgang der Auswerteeinheit zur Verfügung gestellt wird.

Vorteilhafterweise weist die Sensoreinheit, insbesondere die Überprüfungseinheit, eine Erzeugungseinheit auf, die zum Verknüpfen, Kombinieren, Codieren und Scrambling des Signals des Sensors vorgesehen ist. Hierdurch wird das Signal gleichzeitig zur Generierung des Testsignals verwendet. Denkbar ist ebenfalls eine vom Signal des Sensors unabhängige Generierung des Testsignals. Beide erwähnte Methoden der Testsignalgenerierung können in Abhängigkeit der Applikation, insbesondere in Abhängigkeit des Signaltyps gewählt werden. Wichtig in diesem Zusammenhang ist, dass das Testsignal in der Lage ist, die Funktion der Auswerteeinheit eindeutig zu verifizieren.

Vorteilhafterweise ist die Überprüfungseinheit zur Schlüssigkeitsprüfung vorgesehen, indem im einfachsten Fall das erste Auslösesignal der Auswerteeinheit mit dem Testauslösesignal verglichen wird. Wurde das Testsignal mit dem Signal des Sensors gescrambelt bzw. verknüpft oder kombiniert, wird vor der Schlüssigkeitsprüfung das Testauslösesignal descrambelt bzw. die der Überprüfungseinheit bekannte Verknüpfung oder Kombination herausgerechnet. Die Schlüssigkeitsprüfung kann zumindest teilweise ebenfalls von einer Verknüpfungslogik, die unabhängig von der Überprüfungseinheit arbeitet, übernommen werden.

Vorteilhafterweise ist die Überprüfungseinheit zur mehrfachen Funktions- oder Schlüssigkeitsprüfung der Auswerteeinheit vorgesehen. Hierbei überprüft die Überprüfungseinheit nach bestimmten Programmschritten, Kontrollparameter der Auswerteeinheit, wie zum Beispiel Schlüsselwerte oder Zwischenergebnisse. Umgekehrt ist es sinnvoll, die Auswerteeinheit zur einfachen oder mehrfachen Funktions- und/oder Schlüssigkeitsprüfung der Überprüfungseinheit vorzusehen. Die Überprüfungseinheit hat ebenfalls ein Prüfungsschema, welches in Form eines Algorithmus abgearbeitet werden kann. Während des Programmablaufs werden Marken, so genannte Steps, erreicht, die eine Bewertung der ordnungsgemäßen Funktion der Überprüfungseinheit durch die Auswerteeinheit zulassen. Folglich ist eine gegenseitige, gegebenenfalls schrittweise, Kontrolle zwischen Auswerteeinheit und Überprüfungseinheit möglich.

Vorteilhafterweise ist die Auswerteeinheit und/oder die Überprüfungseinheit zur Steuerung mindestens eines Aktors vorgesehen. Die zweikanalige Ausgabe erfolgt damit beispielsweise direkt auf zwei separate Aktoren. Alternativ können auch beide Ergebnisse der Auswerteeinheit und der Überprüfungseinheit vor der Ansteuerung der Aktoren in der Verknüpfungslogik miteinander verknüpft werden.

Vorteilhafterweise kann die Sensoreinheit mit nur einem Sensor betrieben werden. Da jeder denkbare Fehler eines Signalgebers in den so genannten sicheren Zustand führt, besteht nur die Notwendigkeit die fehlerfreie Funktion der Auswerteeinheit unabhängig von der Sensoranzahl sicherzustellen. Die notwendige Überprüfung der Auswerteeinheit durch die Überprüfungseinheit wird auf eine kostengünstige Weise realisiert, nicht zuletzt dadurch, dass nur ein Sensorelement und nur eine Überprüfungseinheit für Funktionsprüfung der Auswerteeinheit bereits ausreichen.

Weitere vorteilhafte Ausbildungen und bevorzugte Weiterbildungen der Erfindung sind der Figurenbeschreibung und/oder den Unteransprüchen zu entnehmen.

Im Folgenden wird die Erfindung anhand der in den Figuren dargestellten Ausführungsbeispiele näher beschrieben und erläutert.

### Es zeigen:

- FIG 1: eine schematische Abbildung einer Sensoreinheit eines transponderbasierten Positionsschalters gemäß dem Stand der Technik,
- FIG 2: eine schematische Abbildung einer Sensoreinheit eines transponderbasierten Positionsschalters mit einem einzigen Messsensor, gemäß dem Stand der Technik,
- FIG 3: eine schematische Abbildung einer Sensoreinheit mit Überprüfungseinheit,
- FIG 4: eine schematische Abbildung einer Sensoreinheit mit Überprüfungseinheit und einer Messsignal basierten Testsignalerzeugung.

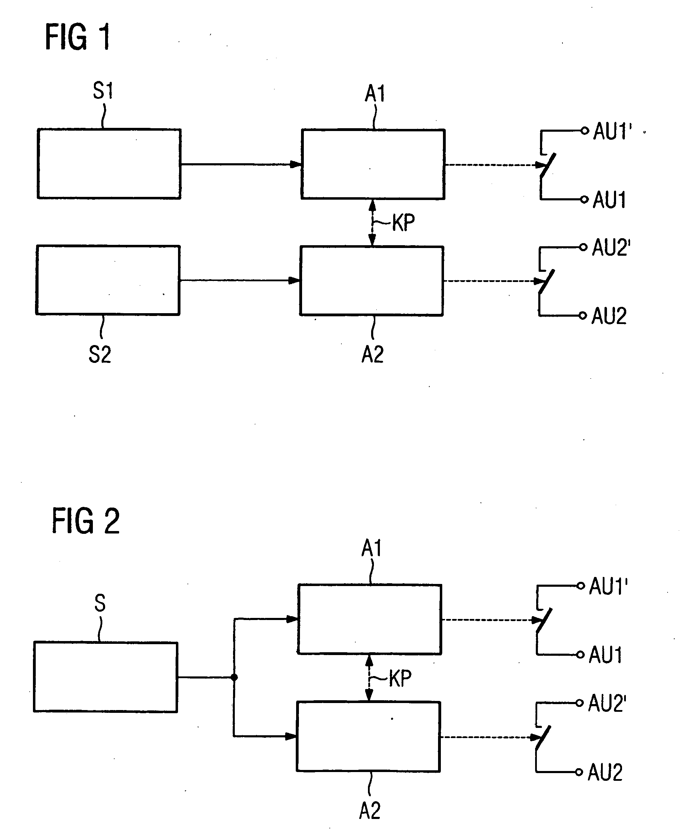

FIG 1 zeigt eine schematische Abbildung einer Sensoreinheit eines transponderbasierten Positionsschalters gemäß dem Stand der Technik.

Die gezeigte Sensoreinheit basiert auf redundanten Sensor-Auswerteeinheiten. Es werden zwei Sensoren S1, S2 und zwei Auswerteeinheiten A1, A2 verwendet, wobei sich die Auswerteeinheiten A1, A1 gegenseitig kontrollieren und jeweils ein Auslösesignal aussenden, falls beide Auswertungen übereinstimmend zu dem Ergebnis führen, dass ein Auslösefall vorliegt. Stimmen die Auswertungen der Auswerteeinheiten A1, A2 nicht überein, so wird nur ein Auslösesignal gesendet, welches dann für die Einleitung einer sicherheitsrelevanten Maßnahme gegebenenfalls nicht ausreicht.

FIG 2 zeigt eine schematische Abbildung einer Sensoreinheit eines transponderbasierten Positionsschalters mit einem einzigen Messsensor, gemäß dem Stand der Technik.

Beide Auswerteeinheiten A1, A2 arbeiten mit einem Sensor S zusammen. Dies spart einen Sensor ein, wobei ein Ausfall des Sensors S am Ausbleiben der Auslösesignale erkannt werden kann.

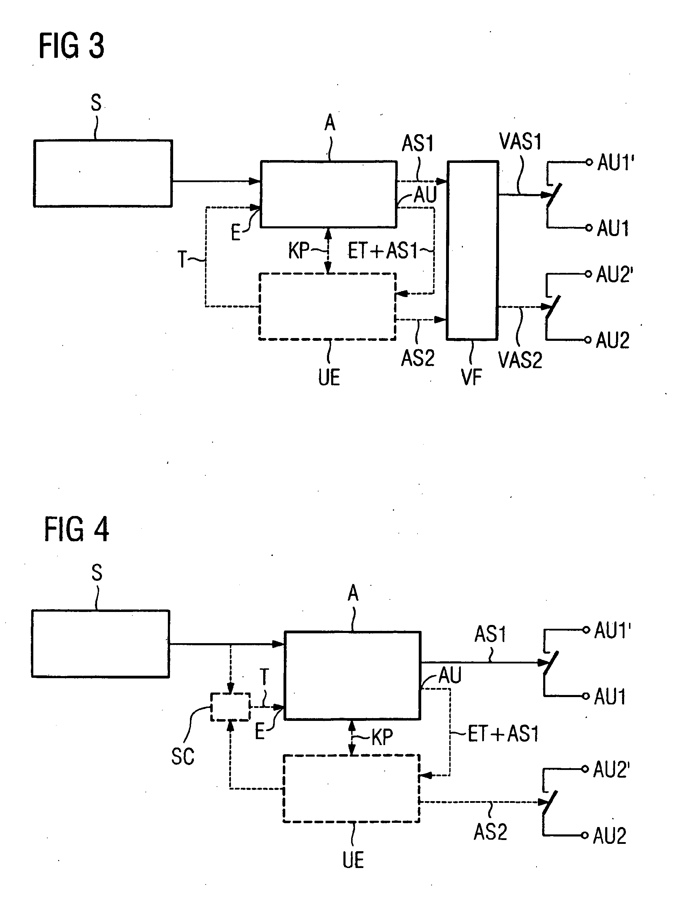

FIG 3 zeigt eine schematische Abbildung einer Sensoreinheit mit Überprüfungseinheit UE.

Ein nicht abgebildeter Signalgeber kommuniziert elektromagnetisch mit dem Messsensor, kurz Sensor S genannt, der Sensor-einheit. Das Messsignal des Sensors S (auch: Signal des Sensors S) wird in eine Auswerteeinheit A eingespeist. Ebenso wird durch den Eingang E das Testsignal T der Überprüfungseinheit UE eingespeist. Das Signal S und das Testsignal T werden in der gleichen Art und Weise von der Auswerteeinheit A ausgewertet. Während des Programmablaufs zur Signalbearbeitung bzw. Signalerkennung können Kontrollparameter (KP) aus Zwischenschritten, wie zum Beispiel Zwischenergebnisse, der Überprüfungseinheit UE von der Auswerteeinheit A überprüft werden und umgekehrt.

Die Auswerteeinheit A gibt ein erstes Auslösesignal AS1 an die Verknüpfungslogik VF weiter und überträgt mittels des Ausgangs AU ein Testauslösesignal ET an die Überprüfungseinheit UE. Die Überprüfungseinheit UE führt ein Schlüssigkeitstest durch, der gegebenenfalls ebenfalls auf dem ersten Auslösesignal AS1 basiert. Der Schlüssigkeitstest kann hierbei auf verschiedenen Funktionen und/oder Überprüfungen basieren. Beispielsweise können Größen von Relevanz sein, die die Länge der Signale, deren Überlapp, deren Intensität, deren Kontrast oder deren Modulation beinhalten. Weiterhin ist ein inhaltlicher Vergleich, insbesondere bei digitalen Signalen denkbar. Hierbei können insbesondere mathematische Funktionen und Verknüpfungen direkt oder indirekt zu einer Ermittlung einer Fehlerrate herangezogen werden. Andere ähnliche Formen der Schlüssigkeitsprüfung sind ebenfalls denkbar.

Nach der Schlüssigkeitsprüfung liegt an einem Ausgang der Überprüfungseinheit UE ein zweites Auslösesignal AS2 vor, welches wie das erste Auslösesignal AS1 an die Verknüpfungslogik VF weitergereicht wird.

Die Verknüpfungslogik VF kann eine einkanalige oder mehrkanalige Ausgabe ausweisen, da die verknüpften Auslösesignale VAS1, VAS2 auf einer zweikanaligen Eingabe in die Verknüpfungslogik VF basieren. In diesem Ausführungsbeispiel führt die Generierung eines ersten verknüpften Ausgabesignals AS1 zur Auslösung einer Kontaktierung der Ausgänge AU1' und AU1. In der gleichen Weise wird ein zweites verknüpftes Auslösesignal VAS2 zur Kontaktierung der Ausgänge AU2', AU2 verwendet. Möglich ist auch eine UND-Verknüpfung, so dass zur Auslösung der Kontaktierung der Ausgänge AU1' und AU1 bzw. AU2' und AU2 beide Auslösesignale AS1, AS2 vorliegen müssen.

Damit wird die Verknüpfungslogik VF Teil der Sicherheitsüberprüfung, weil eine Ausgabe eines der beiden verknüpften Auslösesignalen VAS1, VAS2 nur dann möglich ist, wenn tatsächlich auch beide Eingabesignale, das heißt das erste Auslösesignal AS1 und das zweite Auslösesignal AS2 vorliegen.

Vorteilhafterweise können das erste und zweite Auslösesignal AS1, AS2 direkt zur Steuerung der Kontaktierung der Ausgänge AU1', AU1, AU2', AU2 verwendet werden.

Vorteilhafterweise ist eine Erzeugungseinheit des Testsignals in die Überprüfungseinheit UE integriert.

Weiterhin ist es von Vorteil, wenn die Überprüfungseinheit UE ebenso die Kontrollparameter KP nützt, um in Kombination mit dem Testauslösesignal ET eine umfangreiche Schlüssigkeitsprüfung durchzuführen.

FIG 4 zeigt eine schematische Abbildung einer Sensoreinheit eines transponderbasierten Positionsschalters, wobei die Sensoreinheit auf einer Messsignal basierten Testsignalerzeugung beruht. Ähnlich wie die Sensoreinheit aus FIG 3 weist die Sensoreinheit der FIG 4 einen Sensor S auf, der ein Signal an eine Auswerteeinheit A weiterleitet. Das Testsignal T, welches von der Auswerteeinheit A in gleicher Weise behandelt wird wie das Signal des Sensors S, stammt aus einer Erzeugung in der Überprüfungseinheit UE. Die Vermischung eines beispielsweise mehrfach codierten Signals wird im Scrambler SC realisiert. Die Funktionsweisen der Überprüfungseinheit UE sind ansonsten entsprechend zu der Überprüfungseinheit UE, wie sie aus der FIG 3 bekannt ist.

Vorteilhafterweise wird am Ausgang AU der Auswerteeinheit A nicht nur das Testauslösesignal ET sondern auch das erste Auslösesignal AS1 der Auswerteeinheit A ausgegeben. Dadurch ist die Schlüssigkeitsprüfung der Überprüfungseinheit UE einfacher realisiert, da über den gleichen Kanal beide relevante Signale übermittelt werden.

Der Einsatz einer Verknüpfungslogik VF ist auch bei diesem Ausführungsbeispiel anstatt der direkten Ansteuerung der Aktoren, die an den Ausgängen AU1', AU1 bzw. AU2', AU2 angeschlossen sind, möglich.

Zusammenfassend betrifft die Erfindung eine Sensoreinheit mit Sicherheitssystem zur Verwendung mit einem Signalgeber, wobei mindestens eine Auswerteeinheit zur Auswertung eines Signals eines Sensors und zur Erzeugung eines auf dem Signal basierenden ersten Auslösesignals vorgesehen ist. Eine kompaktere und kostengünstigere Version einer Sensoreinheit soll angegeben werden, die bei hohen Sicherheitsanforderungen zuverlässig arbeitet. Dies wird erreicht durch ein Sicherheitssystem, welches eine Überprüfungseinheit zur Funktionsprüfung der Auswerteeinheit mittels eines Testsignals aufweist wobei die Sensoreinheit einen Scrambler (SC) zur Verschlüsselung des Signals des Sensors (S, S1, S2) mittels des Testsignals (T) beinhaltet. Das Testsignal wird von der Auswerteeinheit in der gleichen Weise verarbeitet, wie das Signal des Messsensors. Eine zweikanalige Ausgabe erfolgt in Abhängigkeit von einer Schlüssigkeitsprüfung der Überprüfungseinheit.

## Patentansprüche

1. Sensoreinheit mit Sicherheitssystem, die mindestens eine Auswerteeinheit (A, A1, A2) zur Auswertung eines Signals eines Sensors (S, S1, S2) und zur Erzeugung eines auf dem Signal basierenden ersten Auslösesignals (AS1) aufweist, wobei das Sicherheitssystem eine Überprüfungseinheit (UE) zur Funktionsprüfung der Auswerteeinheit (A) mittels eines Testsignals (T) aufweist, **dadurch gekennzeichnet, dass** die Sensoreinheit einen Scrambler (SC) zur Verschlüsselung des Signals des Sensors (S, S1, S2) mittels des Testsignals (T) aufweist.

2. Sensoreinheit nach Anspruch 1, wobei die Überprüfungseinheit (UE) zur Erzeugung eines zweiten Auslösesignals (AS2) vorgesehen ist.

3. Sensoreinheit nach einem der Ansprüche 1 oder 2, wobei die Auswerteeinheit (A) zur Erzeugung eines auf dem Testsignal (T) basierenden Testauslösesignals (ET) vorgesehen ist.

4. Sensoreinheit nach einem der vorhergehenden Ansprüche, wobei die Auswerteeinheit (A) einen ersten Eingang für das Signal des Sensors (S, S1, S2) und einen zweiten Eingang (E) für das Testsignal (T) aufweist.

5. Sensoreinheit nach einem der vorhergehenden Ansprüche, wobei der erste und zweite Eingang (E) identisch sind oder zusammen einen Eingang bilden.

6. Sensoreinheit nach einem der vorhergehenden Ansprüche, wobei die Auswerteeinheit (A) einen ersten Ausgang und einen zweiten Ausgang (AU) aufweist.

7. Sensoreinheit nach einem der vorhergehenden Ansprüche, wobei das zweite Auslösesignal (AS2) auf einer Schlüssigkeitsprüfung des Testauslösesignals (ET), insbesondere im Vergleich zum ersten Auslösesignal (AS1) oder im Vergleich mit dem Testsignal (T), basiert.

8. Sensoreinheit nach Anspruch 1, wobei der Scrambler (SC) zum Verknüpfen, Kombinieren, Codieren und Scrambling des Signals des Sensors (S) vorgesehen ist.

9. Sensoreinheit nach einem der vorhergehenden Ansprüche, wobei die Überprüfungseinheit (UE) zur mehrfachen Funktionsprüfung der Auswerteeinheit (A) mittels mehreren Testsignalen (T) und/oder mittels einem oder mehrerer Kontrollparameter (KP) vorgesehen ist.

10. Sensoreinheit nach einem der vorhergehenden Ansprüche, wobei die Auswerteeinheit (A) zur einfachen oder mehrfachen Funktionsprüfung der Überprüfungseinheit (UE) mittels einer oder mehrerer Kontrollparameter (KP) vorgesehen ist.

11. Sensoreinheit nach einem der vorhergehenden Ansprüche, wobei die Funktionsprüfung der Überprüfungseinheit (UE) und/oder der Auswerteeinheit (A) jeweils nach mindestens einem Zwischenschritt eines Verarbeitungsprozesses vorgesehen ist.

12. Sensoreinheit nach einem der vorhergehenden Ansprüche, wobei die Sensoreinheit eine Verknüpfungslogik (VF) aufweist, die zur Verknüpfung des ersten (AS1) und des zweiten Auslösesignals (AS2) zu mindestens einem verknüpften Auslösesignal (VAS1, VAS2) vorgesehen ist.

13. Sensoreinheit nach einem der vorhergehenden Ansprüche, wobei das erste Auslösesignal (AS1), das zweite Auslösesignal (AS2) und/oder das verknüpfte Auslösesignal (VAS1, VAS2) jeweils zur Steuerung mindestens eines Aktors vorgesehen sind.

14. Sensoreinheit nach einem der vorhergehenden Ansprüche, wobei der Sensor (S) der Sensoreinheit zum berührungslosen Empfang von Daten eines Signalgebers vorgesehen ist.

15. Sensoreinheit nach einem der vorhergehenden Ansprüche, wobei am ersten Eingang und am zweiten Eingang (E) Signale zur Einspeisung in die Auswerteeinheit (A) vorgesehen sind, wobei die Signale voneinander diversitär und/oder codiert sind.

16. Sensoreinheit nach einem der vorhergehenden Ansprüche, wobei das Signal des Sensors (S) und/oder das Testsignal (T) zur einfachen oder mehrfachen Codierung vorgesehen sind.

17. Positionsschalter, insbesondere Sicherheitsschalter, mit einer Sensoreinheit nach einem der Ansprüche 1 bis 16 und mit mindestens einem Signalgeber.

## Claims

1. Sensor unit with a safety system which has at least one evaluation unit (A, A1, A2) for evaluating a signal from a sensor (S, S1, S2) and for producing a first trigger signal (AS1) based on the signal, wherein the safety system has a checking unit (UE) for checking the operation of the evaluation unit (A) using a test signal (T), **characterized in that** the sensor unit has a scrambler (SC) for encrypting the signal from the sensor (S, S1, S2) using the test signal (T).

2. Sensor unit according to Claim 1, where the checking unit (UE) is provided for producing a second trigger signal (AS2).

3. Sensor unit according to one of Claims 1 and 2, where the evaluation unit (A) is provided for producing a test trigger signal (ET) based on the test signal (T).

4. Sensor unit according to one of the preceding claims, where the evaluation unit (A) has a first input for the signal from the sensor (S, S1, S2) and a second input (E) for the test signal (T).

5. Sensor unit according to one of the preceding claims, where the first and second inputs (E) are identical or together form one input.

6. Sensor unit according to one of the preceding claims, where the evaluation unit (A) has a first output and a second output (AU).

7. Sensor unit according to one of the preceding claims, where the second trigger signal (AS2) is based on a conclusiveness check on the test trigger signal (ET), particularly in comparison with the first trigger signal (AS1) or in comparison with the test signal (T).

8. Sensor unit according to Claim 1, where the scrambler (SC) is provided for logically combining, combining, encoding and scrambling the signal from the sensor (S).

9. Sensor unit according to one of the preceding claims, where the checking unit (UE) is provided for checking the operation of the evaluation unit (A) a plurality of times using a plurality of test signals (T) and/or using one or more control parameters (KP).

10. Sensor unit according to one of the preceding claims, where the evaluation unit (A) is provided for checking the operation of the checking unit (UE) once or a plurality of times using one or more control parameters (KP).

11. Sensor unit according to one of the preceding claims, where the check on the operation of the checking unit (UE) and/or the evaluation unit (A) is respectively provided after at least one intermediate step in a processing process.

12. Sensor unit according to one of the preceding claims, where the sensor unit has a combinational logic unit (VF) which is provided for logically combining the first (AS1) and the second (AS2) trigger signal to form at least one logically combined trigger signal (VAS1, VAS2).

13. Sensor unit according to one of the preceding claims, where the first trigger signal (AS1), the second trigger signal (AS2) and/or the logically combined trigger signal (VAS1, VAS2) are respectively provided for controlling at least one actuator.

14. Sensor unit according to one of the preceding claims, where the sensor (S) in the sensor unit is provided for contactless reception of data from a signal generator.

15. Sensor unit according to one of the preceding claims, where the first input and the second input (E) are provided with signals for supply to the evaluation unit (A), the signals being diversified from one another and/or encoded.

16. Sensor unit according to one of the preceding claims, where the signal from the sensor (S) and/or the test signal (T) are provided for encoding once or a plurality of times.

17. Position switch, particularly a safety switch, having a sensor unit according to one of Claims 1 to 16 and having at least one signal generator.

## Revendications

1. Unité de détection avec système de sécurité, qui comprend au moins une unité d'évaluation (A, A1, A2) pour l'évaluation d'un signal d'un capteur (S, S1, S2) et pour la génération d'un premier signal de déclenchement (AS1) basé sur le signal, le système de sécurité comprenant une unité de contrôle (UE) pour contrôler le fonctionnement de l'unité d'évaluation (A) au moyen d'un signal d'essai (T), **caractérisée en ce que** l'unité de détection comprend un brouilleur (SC) pour chiffrer le signal du capteur (S, S1, S2) au moyen du signal d'essai (T).

2. Unité de détection selon la revendication 1, l'unité de contrôle (UE) étant prévue pour la génération d'un second signal de déclenchement (AS2).

3. Unité de détection selon l'une des revendications 1 ou 2, l'unité d'évaluation (A) étant prévue pour la génération d'un signal de déclenchement d'essai (ET) se basant sur le signal d'essai (T).

4. Unité de détection selon l'une des revendications précédentes, l'unité d'évaluation (A) étant pourvue d'une première entrée pour le signal du capteur (S, S1, S2) et d'une seconde entrée (E) pour le signal d'essai (T).

5. Unité de détection selon l'une des revendications précédentes, la première et la seconde entrées (E) étant identiques ou formant ensemble une entrée.

6. Unité de détection selon l'une des revendications précédentes, l'unité d'évaluation (A) étant pourvue d'une première sortie et d'une seconde sortie (AU).

7. Unité de détection selon l'une des revendications précédentes, le second signal de déclenchement (AS2) étant basé sur un contrôle de pertinence du signal de déclenchement d'essai (ET), notamment comparé au premier signal de déclenchement (AS1) ou comparé au signal d'essai (T).

8. Unité de détection selon la revendication 1, le brouilleur (SC) étant prévu pour relier, combiner, coder et brouiller le signal du capteur (S).

9. Unité de détection selon l'une des revendications précédentes, l'unité de contrôle (UE) étant prévue pour vérifier plusieurs fois le fonctionnement de l'unité d'évaluation (A) au moyen de plusieurs signaux d'essai (T) et/ou au moyen d'un ou de plusieurs paramètres de contrôle (KP).

10. Unité de détection selon l'une des revendications précédentes, l'unité d'évaluation (A) étant prévue pour vérifier une fois ou plusieurs fois le fonctionnement de l'unité de contrôle (UE) au moyen d'un ou de plusieurs paramètres de contrôle (KP).

11. Unité de détection selon l'une des revendications précédentes, la vérification du fonctionnement de l'unité de contrôle (UE) et/ou de l'unité d'évaluation (A) étant prévue à chaque fois après au moins une étape intermédiaire d'un processus de traitement.

12. Unité de détection selon l'une des revendications précédentes, l'unité de détection ayant une logique combinatoire (VF) qui est prévue pour combiner le premier (AS1) et le second (AS2) signaux de déclenchement pour former au moins un signal de déclenchement combiné (VAS1, VAS2).

13. Unité de détection selon l'une des revendications précédentes, le premier signal de déclenchement (AS1), le second signal de déclenchement (AS2) et/ou le signal de déclenchement combiné (VAS1, VAS2) étant prévus à chaque fois pour commander au moins un actionneur.

14. Unité de détection selon l'une des revendications précédentes, le capteur (S) de l'unité de détection étant prévu pour la réception sans contact de données d'un générateur de signaux.

15. Unité de détection selon l'une des revendications précédentes, des signaux destinés à être alimentés dans l'unité d'évaluation (A) étant prévus au niveau de la première entrée et de la seconde entrée (E), les signaux étant différenciés les uns des autres et/ou codés.

16. Unité de détection selon l'une des revendications précédentes, le signal du capteur (S) et/ou le signal d'essai (T) étant prévus pour un codage simple ou multiple.

17. Interrupteur de position, notamment interrupteur de sécurité, comprenant une unité de détection selon l'une des revendications 1 à 16 et comprenant au moins un générateur de signaux.
